(19) **Europäisches Patentamt / European Patent Office / Office européen des brevets**

(11) **EP 4 380 048 B1**

(12) **FASCICULE DE BREVET EUROPEEN**

(45) Date de publication et mention de la délivrance du brevet:
**21.05.2025 Bulletin 2025/21**

(21) Numéro de dépôt: **22306781.0**

(22) Date de dépôt: **02.12.2022**

(51) Classification Internationale des Brevets (IPC):
**H03F 3/58** *(2006.01)*  **H03F 3/189** *(2006.01)*
**H03F 1/02** *(2006.01)*

(52) Classification Coopérative des Brevets (CPC):
**H03F 3/58; H03F 1/02; H03F 3/189;** H03F 2200/451

(54) **SYSTEME ET PROCEDE DE GESTION DU FONCTIONNEMENT D'UN AMPLIFICATEUR A TUBES A ONDE PROGRESSIVE**

SYSTEM UND VERFAHREN ZUR BETRIEBSVERWALTUNG EINES WANDERFELDRÖHRENVERSTÄRKERS

SYSTEM AND METHOD FOR MANAGING THE OPERATION OF A TRAVELING WAVE TUBE AMPLIFIER

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(43) Date de publication de la demande:
**05.06.2024 Bulletin 2024/23**

(73) Titulaire: **THALES**
**92190 Meudon (FR)**

(72) Inventeurs:
• **PEQUET, Eric**
**6032 MONT-SUR-MARCHIENNE (BE)**
• **LISMONDE, Xavier**
**6032 MONT-SUR-MARCHIENNE (BE)**
• **FAYT, Philippe**
**6032 MONT-SUR-MARCHIENNE (BE)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
**US-A- 6 044 001  US-A1- 2006 234 626**

## Description

### Domaine technique

La présente invention concerne de manière générale le domaine des amplificateurs à tube à onde progressive, et en particulier un système et un procédé de gestion du fonctionnement d'un amplificateur à tubes à onde progressive intégré dans un satellite.

Un amplificateur à tube à onde progressive est utilisé pour transmettre des signaux radiofréquence (RF) de forte puissance. Un amplificateur à tube à onde progressive comprend un ou plusieurs tubes à onde progressive contrôlés (ou alimentés) par une alimentation haute tension.

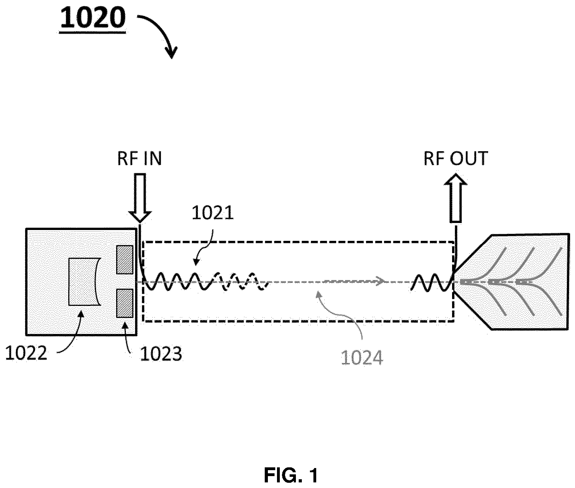

Tel que représenté schématiquement sur la figure 1, un tube à onde progressive comprend une entrée d'un signal radiofréquence RF IN et une sortie d'un signal radiofréquence RF OUT, une ligne à retard 1021, des électrodes comprenant une cathode 1022, une anode 1023, également appelée « anode zéro ».

La cathode 1022 est portée à une température de fonctionnement (1000 °C typiquement) via l'application d'une tension sur le filament. Lorsque la cathode 1022 a atteint la température de fonctionnement, une différence de potentiel électrique entre l'électrode d'anode zéro 1023 et la cathode 1022 est appliquée. En particulier, cette différence de potentiel électrique $Va0$ est encore appelée « tension d'anode zéro ». Lors de l'application de la tension d'anode zéro $Va0$, la cathode 1022 émet un faisceau d'électrons 1024 très dense appelé « courant cathode » et noté $Ik.$

La ligne à retard 1021 (également appelée 'hélice') est une spirale sur laquelle est appliqué le signal (ou onde) hyperfréquence d'entrée RF IN et à travers de laquelle passe le faisceau d'électrons 1024. Lorsque le faisceau d'électrons 1024 traverse l'hélice 1021, une interaction se crée entre celui-ci et le signal RF, et une partie de l'énergie cinétique des électrons du faisceau 1024 est transférée à l'onde hyperfréquence. L'amplitude de l'onde hyperfréquence en sortie radiofréquence RF OUT de l'hélice 1021 est alors amplifiée.

En particulier, la valeur du courant cathode $Ik$ et la vitesse du faisceau d'électrons 1024 d'un tube à onde progressive permet de prédéfinir les performances de ce tube. Certaines performances, dites 'performances RF', peuvent être par exemple la puissance à saturation, correspondant à la puissance maximale, et la bande de fréquence du signal de sortie radiofréquence RF OUT, ou encore le gain du tube, correspondant au rapport entre la puissance de sortie RF OUT et la puissance du signal d'entrée radiofréquence RF IN. D'autres paramètres de performances d'un tube peuvent être sa consommation ou la dissipation énergétique qui prennent en compte de la dispersion d'émissivité des cathodes. Un tube à onde progressive peut être associé à un ou plusieurs points de fonctionnement PF spécifiques et/ou optimaux prenant en compte les performances de ce tube. Ainsi, chaque point de fonctionnement $PF$ d'un tube est associé une valeur spécifique de courant cathode $Ik.$

En outre, l'émissivité d'une cathode 1022 varie principalement avec la température de fonctionnement de la cathode 1022. La température de fonctionnement de la cathode 1022 dépend de la puissance de chauffe du filament. L'émissivité d'une cathode 1022 peut également se dégrader en fonction du temps de fonctionnement de la cathode 1022. Les variations de l'émissivité d'une cathode 1022 génèrent une dérive moyenne des performances de ce tube 1020-n dans le temps. Ainsi, afin de maintenir le flux d'électrons du faisceau 1024 et par conséquence les performances du tube, il est ainsi nécessaire de modifier de manière adéquate la tension d'anode zéro $Va0$ (ou valeur de fonctionnement de tension d'anode zéro), notamment pour une tension sur le filament donnée.

Traditionnellement, pour optimiser les performances radiofréquence d'un tube, l'amplificateur effectue une régulation du flux d'électrons de la cathode de ce tube à partir de la mesure directe du courant cathode $Ik$ du tube.

Au vu de la valeur de haute tension à laquelle est portée la cathode, un circuit de mesure direct du courant cathode $Ik$ est complexe à mettre en œuvre, en particulier compte tenu de l'isolation haute tension à respecter (par exemple 6 à 9KV).

Dans des solutions existantes, il est connu d'utiliser plusieurs tubes à onde progressive connectés à une unique alimentation haute tension. En outre, pour gérer les variations de points de fonctionnement $PF$, c'est-à-dire les variations de flux d'électron de la cathode de tubes à onde progressive, l'alimentation haute tension effectue pour chaque tube une régulation individuelle du point de fonctionnement $PF$ du tube. En particulier, des régulateurs spécifiques à chaque tube effectuent la mesure du courant cathode $Ik$ pour chaque tube, puis transfèrent cette valeur vers un potentiel du régulateur (par exemple la tension cathode, la tension anode ou la masse) et un circuit de régulation de manière à générer une valeur de correction, via une valeur de haute tension de l'anode du tube. La masse, le volume et le coût de chacun des circuits de mesure directe du courant cathode $Ik$ sont ainsi multipliés par le nombre de tubes alimentés par une même alimentation. Cette situation est particulièrement critique, dans certains domaines d'applications, et notamment pour les amplificateurs à tube à onde progressive utilisés dans le domaine spatial.

D'autres exemples de gestion de systèmes amplificateur à tubes à onde progressive sont proposés dans les documents US 6044001 A et US 2006/234626 A1. En particulier, la solution proposée dans le document US 6044001 A fonctionne en boucle ouverte sur une série de points de fonctionnement prédéfinis, et la solution proposée dans le document US 2006/234626 A1 fonctionne en boucle ouverte sur l'enveloppe du signal RF appliqué au tube.

Ainsi, il existe un besoin pour un dispositif amplificateur à tubes à onde progressive capable d'améliorer la gestion du fonctionnement et le réglage de l'alimentation haute tension par rapport aux tubes à onde progressive.

**Résumé de l'invention**

La présente invention vient améliorer la situation en proposant un système satellitaire comprenant un dispositif amplificateur de signaux radiofréquences, le dispositif amplificateur comprenant un module de contrôle et d'alimentation et une pluralité N de tubes à onde progressive. Le module de contrôle et d'alimentation est configuré pour appliquer, pour au moins un des tubes, une valeur de fonctionnement de tension d'anode zéro $Va0_n$, le tube générant un courant cathode $Ik$ en réponse à l'application de la valeur de fonctionnement de tension d'anode zéro $Va0_n$. Le module de contrôle et d'alimentation est configuré pour mesurer au moins une somme des courants cathode $M\Sigma Ik$ associée à la pluralité N de tubes à onde progressive, la au moins une mesure de la somme des courants cathode étant mise en œuvre à partir d'un unique circuit de mesure. Le module de contrôle et d'alimentation est configuré en outre pour déterminer au moins une valeur de fonctionnement corrigée de tension d'anode zéro associée à au moins un des tubes à partir de la au moins une mesure de la somme des courants cathode, le module de contrôle et d'alimentation étant en outre configuré pour appliquer ladite au moins une valeur de fonctionnement corrigée de tension d'anode associée audit au moins un desdits tubes.

Avantageusement, chaque tube peut être associé à un point de fonctionnement $PF_n$ donné associé à une valeur de consigne de courant cathode $CIk_n$ et à une valeur de consigne de tension d'anode zéro $CVa0_n$. Le module de contrôle et d'alimentation peut être configuré pour appliquer à chaque tube la valeur de consigne de tension d'anode zéro $CVa0_n$. Le module de contrôle et d'alimentation peut être configuré pour activer un mode de correction et pour effectuer, pendant le mode de correction :

- une unique mesure de la somme des courants cathode $M\Sigma Ik$ associée à la pluralité N de tubes à onde progressive aux points de fonctionnement $PF_n$,
- pour chaque tube, une détermination d'une valeur corrigée de tension d'anode zéro $DVa0_n$ à partir de l'unique somme mesurée des courants cathode $M\Sigma Ik$, de la valeur de consigne de courant cathode $CIk_n$ et de la valeur de consigne de tension d'anode zéro $CVa0_n$.

Le module de contrôle et d'alimentation peut en outre être configuré pour appliquer, pendant le mode de correction, à chaque tube la valeur corrigée de la tension d'anode zéro $DVa0_n$ associée.

Dans des modes de réalisation, la détermination, pour chaque tube, de la valeur corrigée de tension d'anode zéro $DVa0_n$ peut être effectuée à partir d'une valeur estimée de pervéance $DG_n$ et de la valeur de consigne de courant cathode $CIk_n$, la valeur corrigée de tension d'anode zéro $DVa0_n$ étant défini par : $DVa0_n = \left(\dfrac{CIK_n}{DG_n}\right)^{+2/3}$.

Dans d'autres modes de réalisation, la détermination, pour chaque tube, de la valeur corrigée de tension d'anode zéro $DVa0_n$ du tube à onde progressive peut être effectuée à partir d'une formule de dérivée du courant cathode par rapport à la tension d'anode zéro du tube au point de fonctionnement $PF_n$.

Le module de contrôle et d'alimentation peut être configuré pour effectuer en outre, pendant le mode de correction, une détermination d'un rapport de dérive $Q\Sigma IK$ à partir de l'unique somme mesurée des courants cathode $M\Sigma Ik$, et d'une somme des valeurs de consigne de courant cathode $CIk_n$ de la pluralité N de tubes.

Selon certains modes de réalisation, l'application, pendant le mode de correction, de la valeur corrigée de la tension d'anode zéro $DVa0_n$ au tube peut être effectuée en réponse à une détection d'une dérive de performances d'au moins un tube de la pluralité N de tubes à onde progressive.

le module de contrôle et d'alimentation peut comprendre un ensemble de données comprenant les points de fonctionnement $PF_n$ enregistrés. La dérive de performances peut être déterminée à partir d'une comparaison d'au moins une valeur estimée de pervéance $DG_n$ avec une valeur de consigne de pervéance $CG_n$ comprise dans l'ensemble de données.

le module de contrôle et d'alimentation peut comprendre un ensemble de données comprenant les points de fonctionnement $PF_n$ enregistrés. La dérive de performances peut être déterminée à partir d'une comparaison du rapport de dérive $Q\Sigma IK$ avec un seuil de dérive compris dans l'ensemble de données.

Avantageusement, la dérive de performances peut être déterminée à partir d'une comparaison, pour au moins un des tubes, de la valeur corrigée de la tension d'anode zéro $DVa0_n$ avec la valeur de consigne de tension d'anode zéro $CVa0_n$ associée.

Le module de contrôle et d'alimentation peut comprendre une horloge interne et le mode de correction peut être activé en réponse à une détection d'un horodatage prédéfini.

Le module de contrôle et d'alimentation peut comprendre une horloge interne et un ensemble de données comprenant les points de fonctionnement $PF_n$ enregistrés. Le module de contrôle et d'alimentation peut être configuré pour enregistrer dans une table de calibration et pour associer un horodatage à la valeur corrigée de la tension d'anode zéro $DVa0_n$ et/ou la valeur estimée de la pervéance $DG_n$, et pour enregistrer, à chaque activation du mode de correction, la valeur corrigée de tension d'anode zéro $DVa0_n$ et/ou la valeur estimée de pervéance $DG_n$ dans l'ensemble de données. Le module de contrôle et d'alimentation peut être en outre configuré pour calculer, pour au moins un tube de la pluralité N de tubes à onde progressive, une courbe de tendance à partir de l'ensemble de données, et pour estimer au moins une valeur prédite de tension d'anode zéro $PVa0_n$ et/ou une valeur prédite de pervéance $PG_n$, associée à une valeur d'horodatage ultérieure prédéfinie.

Avantageusement, chaque tube peut être associé à un point de fonctionnement $PF_n$ donné associé à une valeur de tension d'anode zéro de consigne $CVa0_n$ et une valeur de consigne de courant cathode $CIk_n$. Le module de contrôle et d'alimentation peut être configuré pour activer un mode de calibration et pour effectuer, pendant le mode de calibration :

- pour un unique tube de la pluralité N de tubes à onde progressive, une application d'une première valeur de tension d'anode zéro au tube,

- une première mesure de la somme des courants cathode $M\Sigma Ik^1$ de calibration associée à la pluralité N de tubes à onde progressive,

- pour l'unique tube, une application d'une deuxième valeur donnée de tension d'anode zéro $BVa0_n$ au tube,

- une deuxième mesure de la somme des courants cathode $M\Sigma Ik^2$ de calibration associée à la pluralité N de tubes à onde progressive,

- une comparaison des première et deuxième mesures de somme des courants cathode $M\Sigma Ik^1$ et $M\Sigma Ik^2$ de calibration ;

Le module de contrôle et d'alimentation peut être en outre configuré pour effectuer une mise à jour de la valeur de tension d'anode zéro de consigne $CVa0_n$ à partir de la deuxième valeur donnée de tension d'anode zéro $BVa0_n$ et en fonction de la comparaison.

Dans des modes de réalisation, la première valeur de tension d'anode zéro peut être une valeur de référence de tension d'anode zéro $RVa0_n$ associée à une valeur de référence de courant cathode $RIk_n$. Pour l'unique tube, la comparaison peut être effectuée en outre à partir d'une consigne de précision de calibration $\varepsilon$, de la valeur de consigne de courant cathode $CIk_n$ et de la valeur de référence de courant cathode $RIk_n$, telle que $| M\Sigma Ik^2 - M\Sigma Ik^1 - CIk_n + RIk_n | < \varepsilon$.

Le mode de calibration peut être activé en réponse à la détection d'une dérive de performances.

L'invention fournit également un procédé de contrôle et d'alimentation d'une pluralité de N tubes à onde progressive. Le procédé peut être mis en œuvre dans un système satellitaire comprenant les tubes à onde progressive. Le procédé peut comprendre une étape initiale d'application à au moins un des tubes une valeur de fonctionnement de tension d'anode zéro $Va0_n$, le tube générant un courant cathode Ik en réponse à l'application de la valeur de fonctionnement de tension d'anode zéro $Va0_n$. Le procédé peut comprendre les étapes consistant à :

- mesurer au moins une somme des courants cathode associée à la pluralité N de tubes à onde progressive, la au moins une mesure de la somme des courants cathode étant mise en œuvre à partir d'un unique circuit de mesure,
- déterminer au moins une valeur de fonctionnement corrigée de tension d'anode zéro associée à au moins un des tubes à partir de la au moins une mesure de la somme des courants cathode,
- appliquer ladite au moins une valeur de fonctionnement corrigée de tension d'anode associée audit au moins un desdits tubes.

Le système et le procédé de gestion du fonctionnement d'un amplificateur à tubes à onde progressive selon les modes de réalisation de l'invention permettent de simplifier la mise en œuvre de l'alimentation haute tension par rapport aux tubes à onde progressive.

Ils fournissent une solution efficace, tout en limitant les coûts de fabrication de l'amplificateur de signaux radiofréquences de forte puissance, et en réduisant le poids, le volume et les coûts associés.

## Description des figures

D'autres caractéristiques, détails et avantages de l'invention ressortiront à la lecture de la description faite en référence aux dessins annexés donnés à titre d'exemple.

La figure 1 est un schéma représentant un tube à onde progressive, selon l'art antérieur.
La figure 2 est un schéma représentant un amplificateur de signaux radiofréquences, selon des modes de réalisation de l'invention.

La figure 3 est un graphique représentant l'évolution de la tension d'anode zéro à appliquer en fonction d'un rapport de dérive, selon des modes de réalisation de l'invention.

La figure 4 est un organigramme représentant des étapes du procédé de gestion du fonctionnement des tubes à onde progressive, selon des modes de réalisation de l'invention.

La figure 5 est un organigramme représentant des étapes du procédé de gestion du fonctionnement des tubes à onde progressive, selon des modes de réalisation de l'invention.

Des références identiques sont utilisées dans les figures pour désigner des éléments identiques ou analogues. Pour des raisons de clarté, les éléments représentés ne sont pas à l'échelle.

## Description détaillée

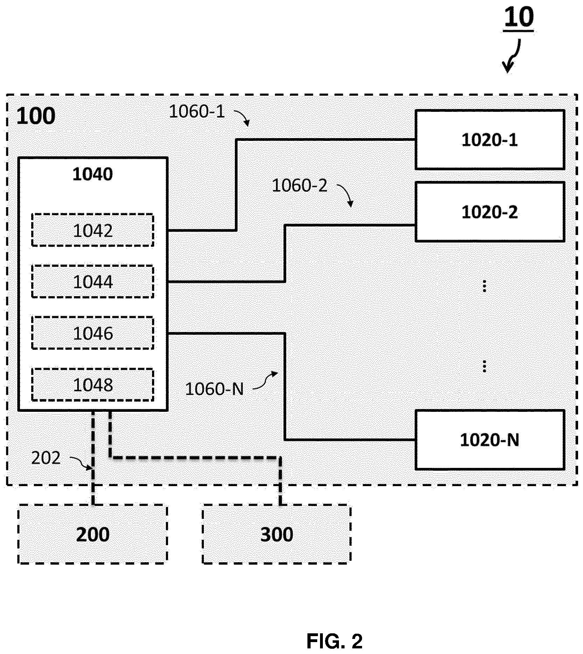

La figure 2 représente schématiquement un dispositif 100 comprenant une pluralité de N tubes à onde progressive 1020-n et un module de contrôle et d'alimentation 1040, selon des modes de réalisation de l'invention.

L'indice 'n' est utilisé pour désigner le nième tube parmi les différents tubes à onde progressive, et est ainsi compris entre 1 et N. Le nombre N est supérieur à 1. Par exemple et sans limitation, le nombre N peut être égal à 4 ou à 8.

Le dispositif 100 est un amplificateur à tubes à onde progressive, encore appelé TWTA (acronyme pour l'expression anglo-saxonne « Traveling Wave Tube Amplifiers »). Dans un exemple d'application de l'invention au domaine satellitaire, le dispositif 100 peut être embarqué dans un système satellitaire 10 et utilisé pour générer et transmettre des signaux radiofréquences de forte puissance vers le sol, par exemple un satellite de télécommunication.

Le dispositif amplificateur 100 de signaux radiofréquences peut délivrer par exemple quelques centaines de watts, et fonctionner à haute fréquence (ou hyperfréquence). En particulier, le dispositif amplificateur 100 peut atteindre des fréquences allant jusqu'à la bande W de 100 GHz par exemple.

Un tube à onde progressive 1020-n, encore appelé TOP ou TWT (acronyme pour l'expression anglo-saxonne « Traveling-Wave Tube »), est un tube à vide allongé utilisé dans le dispositif 100 pour réaliser des amplificateurs en hyperfréquence de faible, moyenne ou forte puissance.

Dans des modes de réalisation, le dispositif 100 peut être un TWTA comportant des TWT multiples. Dans ces modes de réalisation, un ou plusieurs tubes à onde progressive 1020-n peuvent comprendre un boitier intégrant M tubes à onde progressive (non représentés sur les figures).

Le dispositif 100 comprend en outre un ou plusieurs câbles haute tension 1060-n reliant un ou plusieurs tubes 1020-n au module de contrôle et d'alimentation 1040. Un câble haute tension permet d'alimenter en haute tension au moins un tube à onde progressive. Le module de contrôle et d'alimentation 1040 comprend une alimentation haute tension ou un conditionneur électronique de puissance appelé EPC (acronyme de l'expression anglo-saxonne « Electronic Power Conditioner ») configurée pour transformer une tension d'alimentation basse tension en de multiples hautes tensions utilisées pour alimenter les N tubes à onde progressive 1020-n. Le module de contrôle et d'alimentation 1040 peut comprendre un ou plusieurs convertisseurs de puissance DC-DC alimentés en énergie par un bus de puissance (ou bus primaire) 202 relié à une source d'alimentation électrique 200 du satellite 10.

Chaque tube 1020-n est associé à un ou plusieurs points de fonctionnement spécifiques et/ou optimaux notés $PF_{nj}$. L'indice 'j' est utilisé pour désigner un j-ième point de fonctionnement d'un tube à onde progressive 1020-n parmi les différents points de fonctionnement du tube 1020-n, et est ainsi compris entre 1 et J, J étant supérieur ou égal à 1. Chaque point de fonctionnement $PF_{nj}$ spécifique et/ou optimal d'un tube à onde progressive 1020-n est associé à une valeur de consigne de courant cathode, et à une valeur de consigne de tension d'anode zéro. La suite de la description sera faite en référence à une valeur de J égale à 1, un point de fonctionnement d'un tube à onde progressive 1020-n étant alors noté $PF_n$.

Le module de contrôle et d'alimentation 1040 est configuré pour appliquer à chaque tube 1020-n une valeur de consigne de courant cathode, notée $CVa0_n$.

Pour un tube à onde progressive 1020-n, en réponse à l'application de la valeur de consigne $CVa0_n$ de tension d'anode zéro, la cathode 1022 génère un faisceau d'électrons 1024 caractérisé par une valeur spécifique du courant de cathode, notée $Ik_n$.

Dans des modes de réalisation, les points de fonctionnement $PF_n$ (ou $PF_{nj}$) et les valeurs spécifiques de courant cathode associées et les valeurs de consigne de tension d'anode zéro associées peuvent être enregistrés dans un ensemble de données, par exemple dans une unité de stockage 1042 interne au module de contrôle et d'alimentation 1040 et/ou dans une unité 300 externe au dispositif amplificateur 100. L'unité externe 300 peut être par exemple un équipement de programmation ou l'ordinateur de bord noté OBC (acronyme de l'expression anglo-saxonne « On Board Computer ») du satellite 10. La suite de la description sera faite en référence à un ensemble de données représenté sous la forme d'une table de calibration, à titre d'exemple non limitatif. L'unité externe 300 peut également recevoir des consignes provenant d'un centre à terre.

Comme illustré sur la figure 2, le module de contrôle et d'alimentation 1040 comprend une unité de mesure 1044 configurée pour mesurer la valeur de la somme des valeurs spécifiques $Ik_n$ de courant cathode associées à l'ensemble des N tubes à onde progressive 1020-n du dispositif amplificateur 100 de signaux radiofréquences. Cette valeur est encore appelée ci-après 'somme des courants cathode' et notée $M\Sigma Ik$.

Il est à noter que, pour un ou plusieurs tubes 1020-n, la valeur spécifique $Ik_n$ du courant de cathode, généré en réponse à l'application de la valeur de consigne $CVa0_n$ de tension d'anode zéro, peut être différente de la valeur de consigne de courant cathode, notée $Clk_n$, associée à cette valeur de consigne $CVa0_n$ de tension d'anode zéro. Une différence entre la valeur spécifique $Ik_n$ du courant de cathode généré et la valeur de consigne $Clk_n$ de courant cathode résulte d'une variation d'émissivité de la cathode 1022.

Ainsi, pour maintenir les performances de chacun des tubes à onde progressive 1020-n du satellite 10, le module de contrôle et d'alimentation 1040 peut être configuré pour activer un mode de correction et pour effectuer, pendant le mode de correction :

- une mesure de la somme des courants cathode $M\Sigma Ik$, et

- pour chaque tubes 1020-n, une détermination d'une valeur corrigée de tension d'anode zéro, notée $DVa0_n$.

Le module de contrôle et d'alimentation 1040 est en outre configuré pour appliquer, pendant le mode de correction et à chaque tube 1020-n, la valeur corrigée $DVa0_n$ de tension d'anode zéro.

La valeur corrigée $DVa0_n$ de tension d'anode zéro peut être estimée, par exemple via une unité de détermination 1046 interne au module de contrôle et d'alimentation 1040, à partir de la somme mesurée $M\Sigma Ik$ des courants cathode, de la valeur de consigne $Clk_n$ de courant cathode et de la valeur de consigne $CVa0_n$ de tension d'anode zéro.

Dans une première variante de l'invention, la valeur corrigée $DVa0_n$ de tension d'anode zéro peut être déterminée en utilisant une formule de définition de la pervéance $G_n$ d'un tube à onde progressive 1020-n en fonction du courant de cathode et de tension d'anode zéro. La formule la pervéance $G_n$ peut être définie par l'équation (01) suivante :

$$G_n = \frac{Ik_n}{(Va0_n)^{3/2}} \qquad (01)$$

Il est à noter que la pervéance $G_n$ d'un tube à onde progressive 1020-n est spécifique à ce tube 1020-n et est une image de l'émissivité de la cathode. Ainsi, la pervéance $G_n$ du tube à onde progressive 1020-n varie avec la vie du tube 1020-n et peut être associée aux points de fonctionnement spécifiques et/ou optimaux du tube 1020-n.

Dans des modes de réalisation, l'unité de détermination 1046 peut être configurée pour estimer, pour chaque tube 1020-n, la valeur corrigée $DVa0_n$ de tension d'anode zéro à partir d'une valeur de pervéance, notée $DG_n$, estimée en fonction de la valeur de consigne $Clk_n$ de courant cathode du tube 1020-n, tel que défini par l'équation (02) suivante :

$$DVa0_n = \left(\frac{ClK_n}{DG_n}\right)^{+2/3} \qquad (02)$$

Par ailleurs, la valeur estimée $DG_n$ de pervéance d'un tube 1020-n peut être estimée à partir d'une valeur estimée de courant cathode, notée $DIK_n$ et de la valeur tension d'anode zéro de consigne $CVa0_n$, tel que défini par l'équation (03) suivante :

$$DG_n = \frac{DIK_n}{(CVa0_n)^{3/2}} \qquad (03)$$

La valeur estimée $DIK_n$ de courant cathode notamment estimée à partir de la somme mesurée $M\Sigma IK$ des courants cathode.

Dans des modes de réalisation, la valeur estimée $DIK_n$ de courant cathode du tube 1020-n peut être définie à partir de la valeur de consigne $Clk_n$ de courant cathode et d'un rapport de dérive, noté $Q\Sigma IK$, tel que défini par l'équation (04) suivante :

$$DIK_n = CIK_n \times Q\textstyle\sum IK \qquad\qquad (04)$$

Dans l'équation (04), le rapport de dérive $Q\Sigma IK$ peut être défini comme le rapport de la somme mesurée $M\Sigma IK$ des courants cathode sur une somme $\Sigma_n\, CIK_n$ des valeurs de consigne $CIk_n$ de courant cathode sur tous les tubes 1020-n. Ainsi, le rapport de dérive $Q\Sigma IK$ peut être exprimé selon l'équation (05) suivante :

$$Q\textstyle\sum IK = \frac{M\sum IK}{\sum_n CIK_n} \qquad\qquad (05)$$

L'expression de la valeur corrigée $DVa0_n$ de tension d'anode zéro à appliquer pour chaque tube 1020-n peut ainsi être simplifiée en combinant les équations (02), (03), (04), et (05) précédentes. En particulier, l'expression de la valeur corrigée $DVa0_n$ de tension d'anode zéro peut être simplifiée selon les équations (06) ou (07) suivantes :

$$DVa0_n = CVa0_n \times \left(\frac{1}{Q\sum IK}\right)^{+2/3} \qquad\qquad (06)$$

$$DVa0_n = CVa0_n \times \left(\frac{\sum_n CIK_n}{M\sum IK}\right)^{+2/3} \qquad\qquad (07)$$

Dans une deuxième variante de l'invention, la valeur corrigée $DVa0_n$ de tension d'anode zéro peut être effectuée en utilisant une formule de dérivée du courant cathode par rapport à la tension d'anode zéro du tube 1020-n au point de fonctionnement $PF_n$. En particulier, la valeur corrigée $DVa0_n$ de tension d'anode zéro peut être obtenu à partir de l'équation (08) suivante :

$$DVa0_n = CVa0_n \times \left(1 - \frac{2}{3} \times (Q\textstyle\sum IK - 1)\right) \qquad (08)$$

$$DVa0_n = CVa0_n \times \left(1 + \frac{2}{3} \times \left(1 - \frac{M\sum IK}{\sum_n CIK_n}\right)\right) \qquad (09)$$

Conformément aux équations (07) et (09), la valeur corrigé $DVa0_n$ de tension d'anode zéro est estimée à partir de la somme mesurée $M\Sigma Ik$ des courants cathode, de la valeur de consigne $CIk_n$ de courant cathode et de la valeur de consigne $CVa0_n$ de tension d'anode zéro.

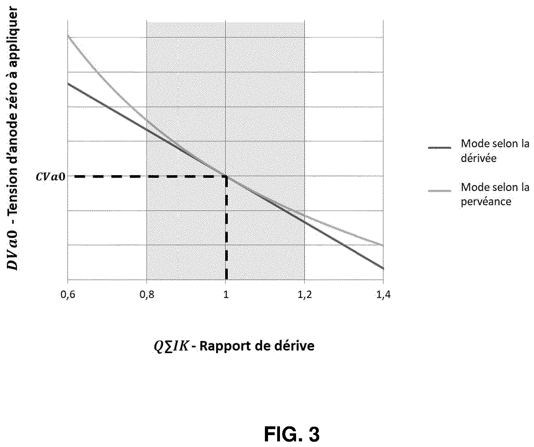

La figure 3 est un graphique représentant l'évolution de la valeur corrigé $DVa0_n$ de tension d'anode zéro à appliquer en fonction du rapport de dérive $Q\Sigma IK$, obtenu à partir des équations (06) et (08), selon la première et deuxième variante de l'invention. Comme illustré sur la figure 3, les deux variantes de l'invention sont équivalentes pour un rapport de dérive $Q\Sigma IK$ très proche de 1, et jusqu'à 0.6 % pour une erreur de $\pm 10\%$ entre la somme mesurée $M\Sigma IK$ des courants cathode et la somme $\Sigma_n\, CIK_n$ des valeurs de consigne de courant cathode sur tous les tubes 1020-n.

Avantageusement, l'unité de détermination 1046 peut être configurée pour estimer, pour chaque tube 1020-n, la valeur estimée $DG_n$ de la pervéance, la valeur estimée $DIK_n$ de courant cathode et/ou le rapport de dérive $Q\Sigma IK$.

En outre, l'unité de stockage 1042 peut être configurée pour enregistrer la valeur corrigée $DVa0_n$ de tension d'anode zéro, ainsi que la valeur estimée $DG_n$ de pervéance et/ou la valeur estimée $DIK_n$ de courant cathode associée au tube 1020-n dans la table de calibration. L'unité de stockage 1042 peut également être configurée pour enregistrer le rapport de dérive $Q\Sigma IK$.

Avantageusement, le module de contrôle et d'alimentation 1040 peut comprendre une horloge interne (non représentée sur les figures), et l'unité de stockage 1042 peut être configurée pour enregistrer et associer à chacune des valeurs enregistrées (valeur estimée $DG_n$ de pervéance, valeur estimée $DIK_n$ de courant cathode, et/ou rapport de dérive $Q\Sigma IK$) une valeur d'horodatage définie par l'horloge interne. Cette valeur d'horodatage peut être définie lors de la mesure de la somme des courants cathode $M\Sigma Ik$ dans le mode de correction.

Dans certains modes de réalisation, l'application des valeurs corrigées $DVa0_n$ de tension d'anode zéro peut être effectuée en réponse à la détection d'une dérive de performances. Par exemple et sans limitation, une dérive de performances peut être déterminée à partir de la comparaison d'une ou plusieurs valeurs estimées $DIK_n$ de courant cathode avec un seuil prédéfini de valeur de courant cathode. Une dérive de performances peut également être déterminée à partir de la comparaison des valeurs corrigées $DVa0_n$ de tension d'anode zéro avec les valeurs de consigne $CVa0_n$ de tension d'anode zéro, de la comparaison des valeurs estimées $DG_n$ de pervéance avec des valeurs de consigne de pervéance, notées $CG_n$ (définies selon l'équation (01) à partir des valeurs de consigne $CVa0_n$ de tension d'anode zéro et des valeurs de consigne $CIk_n$ de courant cathode) et/ou de la comparaison du rapport de dérive $Q\Sigma IK$ avec un seuil de dérive prédéfini.

Chaque tube 1020-n peut également être associé à un point de fonctionnement de référence, noté $PF_{n0}$. Chaque point de fonctionnement de référence $PF_{n0}$ d'un tube à onde progressive 1020-n est associé à une valeur de référence de courant cathode, notée $RIk_n$, et à une valeur de référence de tension d'anode zéro, notée $RVa0_n$.

Avantageusement, le module de contrôle et d'alimentation 1040 peut être configuré pour activer un mode de calibration et pour effectuer, pendant le mode de calibration :

- pour un unique tube 1020-n à calibrer, l'application de la valeur de référence $RVa0_n$ de tension d'anode zéro au tube 1020-n,

- une première mesure de la somme des courants cathode $M\Sigma Ik^1$ de calibration,

- pour cet unique tube 1020-n à calibrer, l'application d'une valeur donnée de tension d'anode zéro, notée $BVa0_n$,

- une deuxième mesure de la somme des courants cathode $M\Sigma Ik^2$ de calibration,

- une comparaison des première et deuxième mesures de somme des courants cathode $M\Sigma Ik^1$ et $M\Sigma Ik^2$ de calibration, et

- une mise à jour de la valeur de consigne $CVa0_n$ de tension d'anode zéro de la table de calibration à partir de la valeur donnée $BVa0_n$ de tension d'anode zéro et en fonction de la comparaison des première et deuxième mesures de somme.

Dans des modes de réalisation, la comparaison effectuée pendant le mode de calibration peut être en outre définie à partir de la valeur de consigne $CIk_n$ de courant cathode, de la valeur de référence $RIk_n$ de courant cathode et d'une valeur de consigne de précision de calibration prédéfinie, notée $\varepsilon$. Par exemple, la comparaison effectuée pendant le mode de calibration peut être défini selon l'équation (10) suivante :

$$| M\textstyle\sum Ik^2 - M\textstyle\sum Ik^1 - CIk_n + RIk_n | < \varepsilon \qquad (10)$$

Ainsi, si l'équation (10) est vérifiée, la valeur de consigne $CVa0_n$ de tension d'anode zéro de la table de calibration peut être remplacée par la valeur donnée $BVa0_n$ de tension d'anode zéro appliquée au tube 1020-n. Si l'égalité (10) n'est pas vérifiée, une autre valeur donnée $BVa0_n$ de tension d'anode zéro est choisie puis appliquée au tube 1020-n et le mode de calibration se poursuit, en effectuant une nouvelle deuxième mesure de la somme des courants cathode $M\Sigma Ik^2$ de calibration, et une nouvelle comparaison de la première mesure de la somme des courants cathode $M\Sigma Ik^1$ de calibration avec la nouvelle deuxième mesure de la somme des courants cathode $M\Sigma Ik^2$ de calibration.

Le choix (c'est-à-dire la recherche) de la valeur donnée $BVa0_n$ de tension d'anode zéro peut être effectué selon des méthodes d'approximation successive par exemple.

Selon certains modes de réalisation, le module de contrôle et d'alimentation 1040 peut être configuré pour effectuer, avant le mode de calibration, une coupure d'alimentation de tension de N-1 tubes et pour appliquer le mode de calibration d'un unique tube 1020-n alors alimenté de manière à générer le faisceau d'électrons 1024 du tube 1020-n. Dans ce cas, le module de contrôle et d'alimentation 1040 peut être configuré pour effectuer, pendant le mode de calibration :

- pour cet unique tube 1020-n, l'application d'une valeur donnée de tension d'anode zéro, notée $BVa0_n$,

- une mesure unique de la somme des courants cathode $M\Sigma Ik^0$ de calibration,

- une comparaison de la somme mesurée $M\Sigma Ik^0$ des courants cathode de calibration avec la valeur de consigne $CIk_n$ de courant cathode, selon l'égalité (11) suivante :

$$M\sum Ik^0 = CIk_n \qquad\qquad (11),$$

et

- une mise à jour de la valeur de consigne $CVa0_n$ de tension d'anode zéro de la table de calibration à partir de la valeur donnée $BVa0_n$ de tension d'anode zéro et en fonction de la comparaison.

Ainsi, si l'équation (11) est vérifiée, la valeur de consigne $CVa0_n$ de tension d'anode zéro de la table de calibration peut être remplacée par la valeur donnée $BVa0_n$ de tension d'anode zéro appliquée au tube 1020-n. Si l'égalité (11) n'est pas vérifiée, une autre valeur donnée $BVa0_n$ de tension d'anode zéro est choisie puis appliquée au tube 1020-n et le mode de calibration se poursuit, en effectuant une nouvelle mesure unique de la somme des courants cathode de calibration $M\Sigma Ik^0$ et une nouvelle comparaison de la valeur de consigne $CIk_n$ de courant cathode avec la nouvelle mesure unique de la somme des courants cathode de calibration $M\Sigma Ik^0$.

Le module de contrôle et d'alimentation 1040 peut être configuré pour réitérer l'application du mode de calibration à un ou plusieurs autres points de fonctionnement $PF_{nj}$ d'un même tube 1020-n, et/ou à un autre tube 1020-n, à plusieurs tubes 1020-n, ou à l'ensemble des tubes 1020-n du système 10. La réitération de l'application du mode de calibration permet une mise à jour complète ou partielle de la table de calibration. Le module de contrôle et d'alimentation 1040 peut également être configuré pour réitérer l'application du mode de calibration en effectuant une coupure d'alimentation de l'unique tube 1020-n à calibrer précédemment contrôlé et en alimentant un autre tube 1020-n unique à calibrer.

Dans des modes de réalisation, le mode de correction et/ou le mode de calibration peuvent être déclenchés suite à l'alimentation d'un ou plusieurs tubes 1020-n, en réponse à un changement de point de fonctionnement d'un tube et/ou en réponse à la détection d'une dérive de performances. Dans d'autres modes de réalisation, le mode de correction et/ou le mode de calibration peuvent également être déclenchés en réponse à une commande du module 1040 ou de l'unité externe 300 du dispositif amplificateur 100. Cette commande de déclenchement du mode de correction et/ou du mode de calibration peut être programmée et/ou induite par un centre à terre.

Avantageusement, dans les modes de réalisation où le module de contrôle et d'alimentation 1040 comprend une horloge interne, le mode de correction et/ou le mode de calibration peuvent être déclenchés en réponse à la détection d'un horodatage prédéfini (par exemple via une commande de déclenchement programmée), par exemple de manière périodique. Par exemple et sans limitation, le mode de correction peut être déclenché toutes les secondes tandis que le mode de calibration peut être déclenché tous les 3 à 6 mois, pendant un certain nombre d'années à partir de la mise en orbite du satellite 10, puis tous les ans.

Ainsi, le module de contrôle et d'alimentation 1040 peut comprendre une unité d'apprentissage 1048 configurée pour calculer, pour un ou plusieurs tubes 1020-n, une courbe de tendance, à partir des valeurs enregistrées dans la table de calibration et des valeurs d'horodatage associées. L'unité d'apprentissage 1048 peut ainsi être configurée pour prédire (i.e. estimer), à partir de la courbe de tendance, en utilisant par exemple une équation ajustée à la courbe de tendance, une ou plusieurs valeurs prédites de tension d'anode zéro, notées $PVa0_n$, et/ou une ou plusieurs valeurs prédites de pervéance, notées $PG_n$, pour une ou plusieurs valeurs prédéfinies d'horodatage.

Dans ces modes de réalisation, le module de contrôle et d'alimentation 1040 peut être configuré pour déterminer la détection d'une dérive de performances à partir des valeurs prédites $PVa0_n$ de tension d'anode zéro et/ou des valeurs prédites $PG_n$ de pervéance. Le module de contrôle et d'alimentation 1040 peut également être configuré pour appliquer la ou les valeurs prédites $PVa0_n$ de tension d'anode zéro. Ce mode de réalisation a l'avantage de compenser le vieillissement du tube 1020-n en diminuant le nombre de mesures à effectuer (i.e. fréquence de modes de correction à activer) et la fréquence de modes de calibration à activer.

En outre, le module de contrôle et d'alimentation 1040 comprend un ou plusieurs circuits (non représentés sur les figures) intégrés spécifique et/ou un circuit digital. Par exemple et sans limitation, un circuit digital peut être tout microcontrôleur. Les différentes unités (et les modes de correction et de contrôle) peuvent être mises en œuvre à l'aide d'un ou plusieurs de ces circuits. En particulier, l'unité de mesure 1044 peut être mise en œuvre à partir d'un unique circuit de mesure.

Les différents modes de réalisation de l'invention ont l'avantage de faciliter la régulation le point de fonctionnement des différents tubes à onde progressive du satellite et de permettre ainsi un contrôle de la dispersion de la pervéance de chacun des tubes du système due à leur vieillissement et aux variations de température. L'activation et la mise en œuvre du mode de calibration ont l'avantage de ne nécessiter que très peu d'interventions manuelles extérieures voire aucune, et de pouvoir être effectuées de manière rapide, durant quelques centaines de millisecondes environ, avec un impact limité sur le trafic de signaux radiofréquence à partir du satellite 10.

En outre les différents modes de réalisation de l'invention présentent l'avantage de réduire au maximum le câblage et le nombre de circuits de mesure, et ainsi de réduire également son coût.

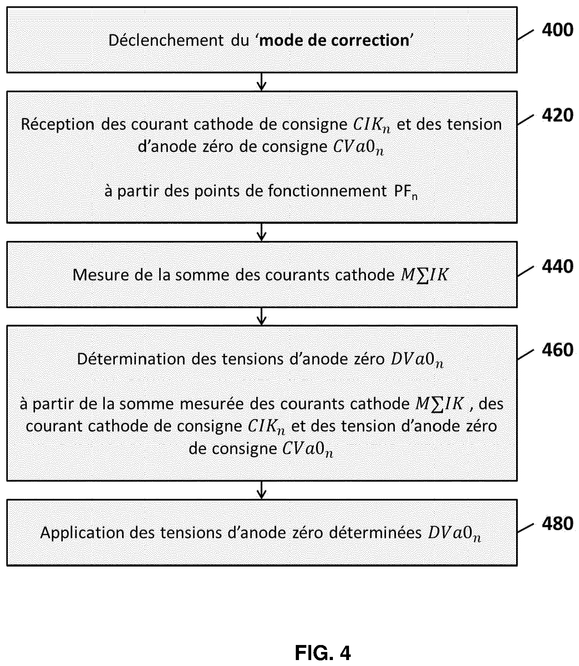

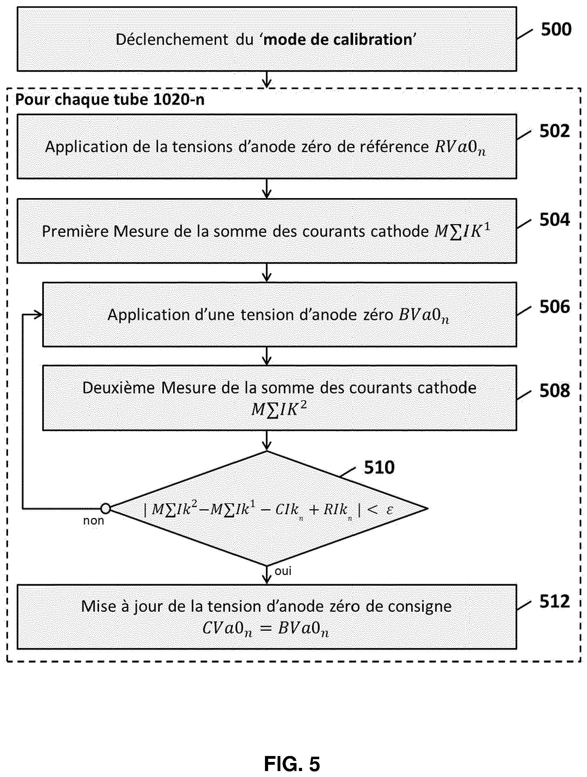

La figure 4 et la figure 5 sont des organigrammes décrivant le procédé, mis en œuvre par un système satellitaire 10 et en particulier par un dispositif modulaire 100 d'amplificateur de signaux radiofréquences, pour contrôler le fonctionnement et le réglage de l'alimentation haute tension par rapport aux tubes à onde progressive, selon des modes de réalisation de l'invention.

A l'étape 400, le mode de correction est activé alors que chaque tube 1020-n est utilisé selon un point de fonctionnement $PF_n$.

A l'étape 420, pour chaque tube 1020-n, la valeur de consigne $CIk_n$ de courant cathode et la valeur de consigne $CVa0_n$ de tension d'anode zéro, associées au point de fonctionnement $PF_n$, sont reçues.

A l'étape 440, en réponse à l'activation du mode de correction, la valeur de la somme des courants cathode $M\Sigma Ik$ des tubes 1020-n est mesurée par le module de contrôle et d'alimentation 1040.

L'homme du métier comprendra aisément que les étapes 400, 420 et 440 peuvent être réalisées de manière simultanée et/ou selon un ordre différent, par exemple un ordre donné défini par le module 1040.

A l'étape 460, pour chaque tube 1020-n, la valeur corrigée $DVa0_n$ de tension d'anode zéro est déterminée à partir de la valeur de la somme mesurée $M\Sigma Ik$ des courants cathode, de la valeur de consigne $CIk_n$ de courant cathode et de la valeur de consigne $CVa0_n$ de tension d'anode zéro.

A l'étape 480, pour chaque tube 1020-n, la valeur corrigée $DVa0_n$ de la tension d'anode zéro est appliquée au tube 1020-n.

A l'étape 500, le mode de calibration est activé.

A l'étape 502, en réponse à l'activation du mode de calibration, la valeur de référence $RVa0_n$ de tension d'anode zéro est appliquée à un unique tube 1020-n à calibrer.

A l'étape 504, une première valeur de la somme des courants cathode $M\Sigma Ik^1$ de calibration est mesurée.

A l'étape 506, une valeur donnée $BVa0_n$ de tension d'anode zéro est appliquée à cet unique tube 1020-n à calibrer.

A l'étape 508, une deuxième valeur de la somme des courants cathode $M\Sigma Ik^2$ de calibration est mesurée.

A l'étape 510, une comparaison est effectuée entre la consigne de précision de calibration $\varepsilon$ et une fonction définie à partir de la deuxième valeur de la somme mesurée $M\Sigma Ik^2$ des courants cathode de calibration, de la première valeur de la somme mesurée $M\Sigma Ik^1$ des courants cathode de calibration, de la valeur de consigne $CIk_n$ de courant cathode et de la valeur de référence $RIk_n$ de courant cathode.

A l'étape 512, une mise à jour de la table de calibration est effectuée en fonction de la comparaison.

L'homme du métier comprendra que le système et le procédé selon les modes de réalisation de l'invention ou des sous éléments de ce système peuvent être mis en œuvre de diverses manières par matériel (« hardware »), logiciel, ou une combinaison de matériel et de logiciels, notamment sous la forme de code de programme pouvant être distribué sous la forme d'un produit de programme, sous diverses formes.

L'invention n'est pas limitée aux modes de réalisation décrits ci-avant à titre d'exemple non limitatif. Elle englobe toutes les variantes de réalisation qui pourront être envisagées par l'homme du métier. En particulier, l'homme du métier comprendra que l'invention n'est pas limitée aux différents modules et unités du système et notamment aux différentes variantes de l'invention pour déterminer la valeur corrigée de tension d'anode zéro décrites à titre d'exemple non limitatif.

**Revendications**

1. Système satellitaire (10) comprenant un dispositif amplificateur (100) de signaux radiofréquences, le dispositif amplificateur (100) comprenant un module de contrôle et d'alimentation (1040) et une pluralité N de tubes à onde progressive (1020-n), le module de contrôle et d'alimentation (1040) étant configuré pour appliquer, pour au moins un desdits tubes (1020-n), une valeur de fonctionnement de tension d'anode $Va0_n$, le tube (1020-n) générant un courant cathode $Ik$ en réponse à l'application de ladite valeur de fonctionnement de tension d'anode $Va0_n$, **caractérisé en ce que** le module de contrôle et d'alimentation (1040) est configuré pour mesurer au moins une somme des courants cathode $M\Sigma Ik$ associée à ladite pluralité N de tubes à onde progressive (1020-n), ladite au moins une mesure de la somme des courants cathode étant mise en œuvre à partir d'un unique circuit de mesure (1044), le module de contrôle et d'alimentation (1040) étant configuré pour déterminer au moins une valeur de fonctionnement corrigée de tension d'anode associée audit au moins un desdits tubes (1020-n) à partir de ladite au moins une mesure de la somme des courants cathode, le module de contrôle et d'alimentation (1040) étant en outre configuré pour appliquer ladite au moins une valeur de fonctionnement corrigée de tension d'anode associée audit au moins un desdits tubes (1020-n).

2. Système (10) selon la revendication 1, dans lequel chaque tube (1020-n) est associé à un point de fonctionnement $PF_n$ donné associé à une valeur de consigne de courant cathode $CIk_n$ et à une valeur de consigne de tension d'anode

$CVa0_n$, le module de contrôle et d'alimentation (1040) étant configuré pour appliquer à chaque tube (1020-n) ladite valeur de consigne de tension d'anode $CVa0_n$, et dans lequel le module de contrôle et d'alimentation (1040) est configuré pour activer (400) un mode de correction et pour effectuer, pendant ledit mode de correction :

    - une unique mesure de la somme des courants cathode $M\Sigma Ik$ associée à ladite pluralité N de tubes à onde progressive (1020-n) aux points de fonctionnement $PF_n$,
    - pour chaque tube (1020-n), une détermination d'une valeur corrigée de tension d'anode $DVa0_n$ à partir de ladite unique somme mesurée des courants cathode $M\Sigma Ik$, de ladite valeur de consigne de courant cathode $CIk_n$ et de ladite valeur de consigne de tension d'anode $CVa0_n$,

le module de contrôle et d'alimentation (1040) étant en outre configuré pour appliquer, pendant ledit mode de correction, à chaque tube (1020-n) ladite valeur corrigée de la tension d'anode $DVa0_n$ associée.

3. Système (10) selon la revendication 2, dans lequel la détermination, pour chaque tube (1020-n), de ladite valeur corrigée de tension d'anode $DVa0_n$ est effectuée à partir d'une valeur estimée de pervéance $DG_n$ et de ladite valeur de consigne de courant cathode $CIk_n$, ladite valeur corrigée de tension d'anode $DVa0_n$ étant défini par :

$$DVa0_n = \left(\frac{CIK_n}{DG_n}\right)^{+2/3}$$

.

4. Système (10) selon la revendication 2, dans lequel la détermination, pour chaque tube (1020-n), de ladite valeur corrigée de tension d'anode $DVa0_n$ du tube à onde progressive (1020-n) est effectuée à partir d'une formule de dérivée du courant cathode par rapport à la tension d'anode du tube (1020-n) au point de fonctionnement $PF_n$.

5. Système (10) selon l'une des revendications 2 à 4, dans lequel le module de contrôle et d'alimentation (1040) est configuré pour effectuer en outre, pendant ledit mode de correction, une détermination d'un rapport de dérive $Q\Sigma IK$ à partir de ladite unique somme mesurée des courants cathode $M\Sigma Ik$, et d'une somme desdites valeurs de consigne de courant cathode $CIk_n$ de ladite pluralité N de tubes (1020-n).

6. Système (10) selon l'une des revendications 2 à 5, dans lequel l'application, pendant ledit mode de correction, de la valeur corrigée de la tension d'anode $DVa0_n$ au tube (1020-n) est effectuée en réponse à une détection d'une dérive de performances d'au moins un tube de ladite pluralité N de tubes à onde progressive (1020-n).

7. Système (10) selon la revendication 6, dans lequel le module de contrôle et d'alimentation (1040) comprend un ensemble de données comprenant les points de fonctionnement $PF_n$ enregistrés, et dans lequel ladite dérive de performances est déterminée à partir d'une comparaison d'au moins une valeur estimée de pervéance $DG_n$ avec une valeur de consigne de pervéance $CG_n$ comprise dans ledit ensemble de données.

8. Système (10) selon les revendications 5 à 6, dans lequel le module de contrôle et d'alimentation (1040) comprend un ensemble de données comprenant les points de fonctionnement $PF_n$ enregistrés, et dans lequel ladite dérive de performances est déterminée à partir d'une comparaison du rapport de dérive $Q\Sigma IK$ avec un seuil de dérive compris dans ledit ensemble de données.

9. Système (10) selon l'une des revendications 6 à 8, dans lequel ladite dérive de performances est déterminée à partir d'une comparaison, pour au moins un desdits tubes (1020-n), de ladite valeur corrigée de la tension d'anode $DVa0_n$ avec ladite valeur de consigne de tension d'anode $CVa0_n$ associée.

10. Système (10) selon l'une des revendications 2 à 9, dans lequel le module de contrôle et d'alimentation (1040) comprend une horloge interne et dans lequel le mode de correction est activé en réponse à une détection d'un horodatage prédéfini.

11. Système (10) selon l'une des revendications 2 à 4, dans lequel le module de contrôle et d'alimentation (1040) comprend une horloge interne et un ensemble de données comprenant les points de fonctionnement $PF_n$ enregistrés, le module de contrôle et d'alimentation (1040) étant configuré pour enregistrer dans une table de calibration et pour associer un horodatage à ladite valeur corrigée de la tension d'anode $DVa0_n$ et/ou ladite valeur estimée de la pervéance $DG_n$, et pour enregistrer, à chaque activation du mode de correction, ladite valeur corrigée de tension d'anode $DVa0_n$ et/ou ladite valeur estimée de pervéance $DG_n$ dans ledit ensemble de données, et dans lequel le module de contrôle et d'alimentation (1040) est en outre configuré pour calculer, pour au moins un tube de ladite pluralité N de tubes à onde progressive (1020-n), une courbe de tendance à partir dudit ensemble de données, et pour estimer au moins une valeur prédite de tension d'anode $PVa0_n$ et/ou une valeur prédite de pervéance $PG_n$, associée à une valeur d'horodatage ultérieure prédéfinie.

12. Système (10) selon la revendication 1, dans lequel chaque tube (1020-n) est associé à un point de fonctionnement $PF_n$ donné associé à une valeur de tension d'anode de consigne $CVa0_n$ et une valeur de consigne de courant cathode $CIk_n$, et dans lequel le module de contrôle et d'alimentation (1040) est configuré pour activer (500) un mode de calibration et pour effectuer, pendant ledit mode de calibration :

- pour un unique tube de ladite pluralité N de tubes à onde progressive (1020-n), une application d'une première valeur de tension d'anode au tube (1020-n),
- une première mesure de la somme des courants cathode $M\Sigma Ik^1$ de calibration associée à ladite pluralité N de tubes à onde progressive (1020-n),
- pour ledit unique tube (1020-n), une application d'une deuxième valeur donnée de tension d'anode $BVa0_n$ au tube (1020-n),
- une deuxième mesure de la somme des courants cathode $M\Sigma Ik^2$ de calibration associée à ladite pluralité N de tubes à onde progressive (1020-n),
- une comparaison desdites première et deuxième mesures de somme des courants cathode $M\Sigma Ik^1$ et $M\Sigma Ik^2$ de calibration ;

le module de contrôle et d'alimentation (1040) étant en outre configuré pour effectuer une mise à jour de ladite valeur de tension d'anode de consigne $CVa0_n$ à partir de ladite deuxième valeur donnée de tension d'anode $BVa0_n$ et en fonction de ladite comparaison.

13. Système (10) selon la revendication 12, dans lequel ladite première valeur de tension d'anode est une valeur de référence de tension d'anode $RVa0_n$ associée à une valeur de référence de courant cathode $RIk_n$, et dans lequel, pour ledit unique tube (1020-n), ladite comparaison est effectuée en outre à partir d'une consigne de précision de calibration $\varepsilon$, de ladite valeur de consigne de courant cathode $CIk_n$ et de ladite valeur de référence de courant cathode $RIk_n$, telle que $| M\Sigma Ik^2 - M\Sigma Ik^1 - CIk_n + RIk_n | < \varepsilon$.

14. Système (10) selon l'une des revendications 12 ou 13, dans lequel le mode de calibration est activé en réponse à la détection d'une dérive de performances.

15. Procédé de contrôle et d'alimentation d'une pluralité de N tubes à onde progressive (1020-n), le procédé étant mis en œuvre dans un système satellitaire (10) comprenant lesdits tubes à onde progressive (1020-n), le procédé comprenant une étape initiale d'application à au moins un desdits tubes (1020-n) une valeur de fonctionnement de tension d'anode $Va0_n$, le tube (1020-n) générant un courant cathode $Ik$ en réponse à l'application de ladite valeur de fonctionnement de tension d'anode $Va0_n$, **caractérisé en ce que** le procédé comprend les étapes consistant à :

- mesurer (440, 504, 508) au moins une somme des courants cathode associée à ladite pluralité N de tubes à onde progressive (1020-n), ladite au moins une mesure de la somme des courants cathode étant mise en œuvre à partir d'un unique circuit de mesure (1044),
- déterminer (460, 510) au moins une valeur de fonctionnement corrigée de tension d'anode associée audit au moins un desdits tubes (1020-n) à partir de ladite au moins une mesure de la somme des courants cathode,
- appliquer (480, 514) ladite au moins une valeur de fonctionnement corrigée de tension d'anode associée audit au moins un desdits tubes (1020-n).

**Patentansprüche**

1. Satellitensystem (10), das eine Hochfrequenzsignalverstärkervorrichtung (100) umfasst, wobei die Verstärkervorrichtung (100) ein Steuer- und Versorgungsmodul (1040) und eine Vielzahl N von Wanderfeldröhren (1020-n) umfasst, wobei das Steuer- und Versorgungsmodul (1040) zum Anlegen, für mindestens eine der Röhren (1020-n), eines Anodenspannungsbetriebswerts $Va0_n$ konfiguriert ist, wobei die Röhre (1020-n) als Reaktion auf das Anlegen des Anodenspannungsbetriebswerts $Va0_n$ einen Kathodenstrom $Ik$ erzeugt, **dadurch gekennzeichnet, dass** das Steuer- und Versorgungsmodul (1040) zum Messen mindestens einer der Vielzahl N von Wanderfeldröhren (1020-n) zugeordneten Summe der Kathodenströme $M\Sigma Ik$ konfiguriert ist, wobei die mindestens eine Messung der Summe der Kathodenströme auf der Basis einer einzigen Messschaltung (1044) implementiert wird, wobei das Steuer- und Versorgungsmodul (1040) zum Bestimmen mindestens eines der mindestens einen der Röhren (1020-n) zugeordneten korrigierten Anodenspannungsbetriebswerts auf der Basis der mindestens einen Messung der Summe der Kathodenströme konfiguriert ist, wobei das Steuer- und Versorgungsmodul (1040) ferner zum Anlegen des mindestens einen zugeordneten korrigierten Anodenspannungsbetriebswerts an die mindestens eine der Röhren (1020-n) konfiguriert ist.

2. System (10) nach Anspruch 1, wobei jede Röhre (1020-n) einem gegebenen Betriebspunkt $PF_n$ zugeordnet ist, der einem Kathodenstromsollwert $CIk_n$ und einem Anodenspannungssollwert $CVa0_n$ zugeordnet ist, wobei das Steuer- und Versorgungsmodul (1040) zum Anlegen des Anodenspannungssollwerts $CVa0_n$ an jede Röhre (1020-n) konfiguriert ist, und wobei das Steuer- und Versorgungsmodul (1040) konfiguriert ist zum Aktivieren (400) eines Korrekturmodus und zum Durchführen während des Korrekturmodus von Folgendem:

- einer einzelnen Messung der Summe der Kathodenströme $M\Sigma Ik$, die der Vielzahl N von Wanderfeldröhren (1020-n) an den Betriebspunkten $PF_n$ zugeordnet sind,
- einer Bestimmung, für jede Röhre (1020-n), eines korrigierten Anodenspannungswerts $DVa0_n$ auf der Basis der einzelnen gemessenen Summe der Kathodenströme $M\Sigma Ik$, des Kathodenstromsollwerts $CIk_n$ und des Anoden- spannungssollwerts $CVa0_n$,

wobei das Steuer- und Versorgungsmodul (1040) ferner zum Anlegen, während des Korrekturmodus, des zuge- ordneten korrigierten Anodenspannungswerts $DVa0_n$ an jede Röhre (1020-n) konfiguriert ist.

3. System (10) nach Anspruch 2, wobei die Bestimmung des korrigierten Anodenspannungswerts $DVa0_n$ für jede Röhre (1020-n) auf der Basis eines geschätzten Perveanzwerts $DG_n$ und des Kathodenstromsollwerts $CIk_n$ durchgeführt wird, wobei der korrigierte Anodenspannungswert $DVa0_n$ definiert wird durch:

$$DVa0_n = \left(\frac{CIK_n}{DG_n}\right)^{+2/3}.$$

4. System (10) nach Anspruch 2, wobei die Bestimmung, für jede Röhre (1020-n), des korrigierten Anodenspannungs- werts $DVa0_n$ der Wanderfeldröhre (1020-n) auf der Basis einer Ableitungsformel für den Kathodenstrom in Bezug auf die Anodenspannung der Röhre (1020-n) am Betriebspunkt $PF_n$ durchgeführt wird.

5. System (10) nach einem der Ansprüche 2 bis 4, wobei das Steuer- und Versorgungsmodul (1040) zum ferneren Durchführen, während des Korrekturmodus, einer Bestimmung eines Driftverhältnisses $Q\Sigma IK$ auf der Basis der einzelnen gemessenen Summe der Kathodenströme $M\Sigma Ik$ und einer Summe der Kathodenstromsollwerte $CIk_n$ der Vielzahl N von Röhren (1020-n) konfiguriert ist.

6. System (10) nach einem der Ansprüche 2 bis 5, wobei das Anlegen, während des Korrekturmodus, des korrigierten Anodenspannungswerts $DVa0_n$ an die Röhre (1020-n) als Reaktion auf eine Erkennung einer Leistungsdrift von mindestens einer Röhre aus der Vielzahl N von Wanderfeldröhren (1020-n) durchgeführt wird.

7. System (10) nach Anspruch 6, wobei das Steuer- und Versorgungsmodul (1040) einen Datensatz umfasst, der die gespeicherten Betriebspunkte $PF_n$ umfasst, und wobei die Leistungsdrift auf der Basis eines Vergleichs von mindestens einem geschätzten Perveanzwert $DG_n$ mit einem in dem Datensatz umfassten Perveanzsollwert $CG_n$ bestimmt wird.

8. System (10) nach den Ansprüchen 5 bis 6, wobei das Steuer- und Versorgungsmodul (1040) einen Datensatz umfasst, der die gespeicherten Betriebspunkte $PF_n$ umfasst, und wobei die Leistungsdrift auf der Basis eines Vergleichs des Driftverhältnisses $Q\Sigma IK$ mit einem in dem Datensatz umfassten Driftschwellenwert bestimmt wird.

9. System (10) nach einem der Ansprüche 6 bis 8, wobei die Leistungsdrift auf der Basis eines Vergleichs, für mindestens eine der Röhren (1020-n), des korrigierten Anodenspannungswerts $DVa0_n$ mit dem zugeordneten Anodenspannungssollwert $CVa0_n$ bestimmt wird.

10. System (10) nach einem der Ansprüche 2 bis 9, wobei das Steuer- und Versorgungsmodul (1040) einen internen Taktgeber umfasst und wobei der Korrekturmodus als Reaktion auf eine Erkennung eines vordefinierten Zeitstempels aktiviert wird.

11. System (10) nach einem der Ansprüche 2 bis 4, wobei das Steuer- und Versorgungsmodul (1040) einen internen Taktgeber und einen Datensatz umfasst, der die gespeicherten Betriebspunkte $PF_n$ umfasst, wobei das Steuer- und Versorgungsmodul (1040) so konfiguriert ist, dass es den korrigierten Anodenspannungswert $DVa0_n$ und/oder den geschätzten Perveanzwert $DG_n$ in einer Kalibrierungstabelle speichert und diese einem Zeitstempel zuordnet, und bei jeder Aktivierung des Korrekturmodus den korrigierten Anodenspannungswert $DVa0_n$ und/oder den geschätzten Perveanzwert $DG_n$ in dem Datensatz speichert, und wobei das Steuer- und Versorgungsmodul (1040) ferner zum Berechnen, für mindestens eine Röhre aus der Vielzahl N von Wanderfeldröhren (1020-n), einer Trendkurve auf der Basis des Datensatzes, und zum Schätzen mindestens eines vorhergesagten Anodenspannungswerts $PVa0_n$ und/oder eines vorhergesagten Perveanzwerts $PG_n$, der einem vordefinierten späteren Zeitstempelwert zugeordnet ist, konfiguriert ist.

12. System (10) nach Anspruch 1, wobei jede Röhre (1020-n) einem gegebenen Betriebspunkt $PF_n$ zugeordnet ist, der einem Anodenspannungssollwert $CVa0_n$ und einem Kathodenstromsollwert $CIk_n$ zugeordnet ist, und wobei das Steuer- und Versorgungsmodul (1040) konfiguriert ist zum Aktivieren (500) eines Kalibrierungsmodus und zum Durchführen während des Kalibrierungsmodus von Folgendem:

- einem Anlegen, für eine einzelne Röhre aus der Vielzahl N von Wanderfeldröhren (1020-n), eines ersten Anodenspannungswerts an die Röhre (1020-n),
- einer ersten Messung der Summe der Kalibrierungskathodenströme $M\Sigma Ik^1$, die der Vielzahl N von Wanderfeldröhren (1020-n) zugeordnet ist,
- einem Anlegen, für die einzelne Röhre (1020-n), eines zweiten gegebenen Anodenspannungswerts $BVa0_n$ an die Röhre (1020-n),
- einer zweiten Messung der Summe der Kalibrierungskathodenströme $M\Sigma Ik^2$, die der Vielzahl N von Wanderfeldröhren (1020-n) zugeordnet ist,
- einem Vergleich der ersten und der zweiten Messung der Summe der Kalibrierungskathodenströme $M\Sigma Ik^1$ und $M\Sigma Ik^2$;

wobei das Steuer- und Versorgungsmodul (1040) ferner zum Durchführen einer Aktualisierung des Anodenspannungssollwerts $CVa0_n$ auf der Basis des zweiten gegebenen Anodenspannungswerts $BVa0_n$ und gemäß dem Vergleich konfiguriert ist.

13. System (10) nach Anspruch 12, wobei der erste Anodenspannungswert ein Anodenspannungsreferenzwert $RVa0_n$ ist, der einem Kathodenstromreferenzwert $RIk_n$ zugeordnet ist, und wobei für die einzelne Röhre (1020-n) der Vergleich ferner auf der Basis eines Kalibrierungsgenauigkeitssollwerts $\varepsilon$, des Kathodenstromsollwerts $CIk_n$ und des Kathodenstromreferenzwerts $RIk_n$ durchgeführt wird, sodass $| M\Sigma Ik^2 - M\Sigma Ik^1 - CIk_n + RIk_n | < \varepsilon$.

14. System (10) nach Anspruch 12 oder 13, wobei der Kalibrierungsmodus als Reaktion auf die Erkennung einer Leistungsdrift aktiviert wird.

15. Verfahren zum Steuern und Versorgen einer Vielzahl von N Wanderfeldröhren (1020-n), wobei das Verfahren in einem Satellitensystem (10) implementiert wird, das die Wanderfeldröhren (1020-n) umfasst, wobei das Verfahren einen Anfangsschritt des Anlegens eines Anodenspannungsbetriebswerts $Va0_n$ an mindestens eine der Röhren (1020-n) umfasst, wobei die Röhre (1020-n) als Reaktion auf das Anlegen des Anodenspannungsbetriebswerts $Va0_n$ einen Kathodenstrom $Ik$ erzeugt, **dadurch gekennzeichnet, dass** das Verfahren die folgenden Schritte umfasst:

- Messen (440, 504, 508) mindestens einer Summe der Kathodenströme, die der Vielzahl N von Wanderfeldröhren (1020-n) zugeordnet ist, wobei die mindestens eine Messung der Summe der Kathodenströme auf der Basis einer einzigen Messschaltung (1044) implementiert wird,
- Bestimmen (460, 510) mindestens eines der mindestens einen der Röhren (1020-n) zugeordneten korrigierten Anodenspannungsbetriebswerts auf der Basis der mindestens einen Messung der Summe der Kathodenströme,
- Anlegen (480, 514) des mindestens einen zugeordneten korrigierten Anodenspannungsbetriebswerts an die mindestens eine der Röhren (1020-n).

## Claims

1. A satellite system (10) comprising a radio frequency signal amplifier device (100), the amplifier device (100) comprising a control and supply module (1040) and a plurality N of travelling wave tubes (1020-n), the control and supply module (1040) being configured to apply, for at least one of said tubes (1020-n), an anode voltage

operating value $Va0_n$, the tube (1020-n) generating a cathode current $Ik$ in response to the application of said anode voltage operating value $Va0_n$, **characterised in that** the control and supply module (1040) is configured to measure at least one sum of the cathode currents $M\Sigma Ik$ associated with said plurality N of travelling wave tubes (1020-n), said at least one measurement of the sum of the cathode currents being implemented based on a single measuring circuit (1044), the control and supply module (1040) being configured to determine at least one corrected anode voltage operating value associated with said at least one of said tubes (1020-n) based on said at least one measurement of the sum of the cathode currents, the control and supply module (1040) being further configured to apply said at least one associated corrected anode voltage operating value to said at least one of said tubes (1020-n).

2. The system (10) according to claim 1, wherein each tube (1020-n) is associated with a given operating point $PF_n$ associated with a cathode current setpoint value $CIk_n$ and an anode voltage setpoint value $CVa0_n$, the control and supply module (1040) being configured to apply said anode voltage setpoint value $CVa0_n$ to each tube (1020-n), and wherein the control and supply module (1040) is configured to activate (400) a correction mode and to perform, during said correction mode:

   - a single measurement of the sum of the cathode currents $M\Sigma Ik$ associated with said plurality N of travelling wave tubes (1020-n) at the operating points $PF_n$,
   - for each tube (1020-n), a determination of a corrected anode voltage value $DVa0_n$ based on said single measured sum of the cathode currents $M\Sigma Ik$, said cathode current setpoint value $CIk_n$ and said anode voltage setpoint value $CVa0_n$,

   the control and supply module (1040) being further configured to apply, during said correction mode, said associated corrected anode voltage value $DVa0_n$ to each tube (1020-n).

3. The system (10) according to claim 2, wherein the determination, for each tube (1020-n), of said corrected anode voltage value $DVa0_n$ is performed based on an estimated perveance value $DG_n$ and said cathode current setpoint value $CIk_n$, said corrected anode voltage value $DVa0_n$ being defined by:

$$DVa0_n = \left(\frac{CIK_n}{DG_n}\right)^{+2/3}.$$

4. The system (10) according to claim 2, wherein the determination, for each tube (1020-n), of said corrected anode voltage value $DVa0_n$ of the travelling wave tube (1020-n) is performed based on a derivative formula for the cathode current with respect to the anode voltage of the tube (1020-n) at the operating point $PF_n$.

5. The system (10) according to one of claims 2 to 4, wherein the control and supply module (1040) is configured to further perform, during said correction mode, a determination of a drift ratio $Q\Sigma IK$ on the basis of said single measured sum of the cathode currents $M\Sigma Ik$ and a sum of said cathode current setpoint values $CIk_n$ of said plurality N of tubes (1020-n).

6. The system (10) according to one of claims 2 to 5, wherein the application, during said correction mode, of the corrected anode voltage value $DVa0_n$ to the tube (1020-n) is performed in response to a detection of a performance drift of at least one tube from said plurality N of travelling wave tubes (1020-n).

7. The system (10) according to claim 6, wherein the control and supply module (1040) comprises a data set comprising the stored operating points $PF_n$, and wherein said performance drift is determined based on a comparison of at least one estimated perveance value $DG_n$, with a perveance setpoint value $CG_n$ comprised in said data set.

8. The system (10) according to claims 5 to 6, wherein the control and supply module (1040) comprises a data set comprising the stored operating points $PF_n$, and wherein said performance drift is determined based on a comparison of the drift ratio $Q\Sigma IK$ with a drift threshold comprised in said data set.

9. The system (10) according to one of claims 6 to 8, wherein said performance drift is determined based on a comparison, for at least one of said tubes (1020-n), of said corrected anode voltage value $DVa0_n$ with said associated anode voltage setpoint value $CVa0_n$.

10. The system (10) according to one of claims 2 to 9, wherein the control and supply module (1040) comprises an internal clock and wherein the correction mode is activated in response to a detection of a predefined time stamp.

11. The system (10) according to one of claims 2 to 4, wherein the control and supply module (1040) comprises an internal clock and a data set comprising the stored operating points $PF_n$, the control and supply module (1040) being configured to store, in a calibration table, and to associate a time stamp with said corrected anode voltage value $DVa0_n$ and/or said estimated perveance value $DG_n$, and to store, each time the correction mode is activated, said corrected anode voltage value $DVa0_n$ and/or said estimated perveance value $DG_n$ in said data set, and wherein the control and supply module (1040) is further configured to calculate, for at least one tube from said plurality N of travelling wave tubes (1020-n), a trend curve based on said data set, and to estimate at least one predicted anode voltage value $PVa0_n$ and/or a predicted perveance value $PG_n$, associated with a predefined subsequent time stamp value.

12. The system (10) according to claim 1, wherein each tube (1020-n) is associated with a given operating point $PF_n$ associated with an anode voltage setpoint value $CVa0_n$ and a cathode current setpoint value $CIk_n$, and wherein the control and supply module (1040) is configured to activate (500) a calibration mode and to perform, during said calibration mode:

- for a single tube from said plurality N of travelling wave tubes (1020-n), an application of a first anode voltage value to the tube (1020-n),
- a first measurement of the sum of the calibration cathode currents $M\Sigma Ik^1$ associated with said plurality N of travelling wave tubes (1020-n),
- for said single tube (1020-n), an application of a given second anode voltage value $BVa0_n$ to the tube (1020-n),
- a second measurement of the sum of the calibration cathode currents $M\Sigma Ik^2$ associated with said plurality N of travelling wave tubes (1020-n),
- a comparison of said first and second measurements of the sum of the calibration cathode currents $M\Sigma Ik^1$ and $M\Sigma Ik^2$;

the control and supply module (1040) being further configured to perform an update of said anode voltage setpoint value $CVa0_n$ based on said given second anode voltage value $BVa0_n$ and according to said comparison.

13. The system (10) according to claim 12, wherein said first anode voltage value is an anode voltage reference value $RVa0_n$ associated with a cathode current reference value $RIk_n$, and wherein, for said single tube (1020-n), said comparison is further performed based on a calibration accuracy setpoint $\varepsilon$, on said cathode current setpoint value $CIk_n$ and on said cathode current reference value $RIk_n$, such that $| M\Sigma Ik^2 - M\Sigma Ik^1 - CIk_n + RIk_n | < \varepsilon$.

14. The system (10) according to claim 12 or 13, wherein the calibration mode is activated in response to the detection of a performance drift.

15. A method for controlling and supplying power to a plurality of N travelling wave tubes (1020-n), the method being implemented in a satellite system (10) comprising said travelling wave tubes (1020-n), the method comprising an initial step of applying an anode voltage operating value $Va0_n$ to at least one of said tubes (1020-n), the tube (1020-n) generating a cathode current $Ik$ in response to the application of said anode voltage operating value $Va0_n$, **characterised in that** the method comprises the steps of:

- measuring (440, 504, 508) at least one sum of the cathode currents associated with said plurality N of travelling wave tubes (1020-n), said at least one measurement of the sum of the cathode currents being implemented based on a single measuring circuit (1044),
- determining (460, 510) at least one corrected anode voltage operating value associated with said at least one of said tubes (1020-n) based on said at least one measurement of the sum of the cathode currents,
- applying (480, 514) said at least one associated corrected anode voltage operating value to said at least one of said tubes (1020-n).

**1020**

RF IN

RF OUT

1021

1022

1023

1024

**FIG. 1**

FIG. 2

EP 4 380 048 B1

EP 4 380 048 B1

**FIG. 3**

19

Déclenchement du 'mode de correction' 400

Réception des courant cathode de consigne $CIK_n$ et des tension d'anode zéro de consigne $CVa0_n$

à partir des points de fonctionnement PF$_n$ 420

Mesure de la somme des courants cathode $M\sum IK$ 440

Détermination des tensions d'anode zéro $DVa0_n$

à partir de la somme mesurée des courants cathode $M\sum IK$, des courant cathode de consigne $CIK_n$ et des tension d'anode zéro de consigne $CVa0_n$ 460

Application des tensions d'anode zéro déterminées $DVa0_n$ 480

**FIG. 4**

Déclenchement du 'mode de calibration' — 500

Pour chaque tube 1020-n

Application de la tensions d'anode zéro de référence $RVa0_n$ — 502

Première Mesure de la somme des courants cathode $M\sum IK^1$ — 504

Application d'une tension d'anode zéro $BVa0_n$ — 506

Deuxième Mesure de la somme des courants cathode $M\sum IK^2$ — 508

510

non $\quad | M\sum Ik^2 - M\sum Ik^1 - CIk_n + RIk_n | < \varepsilon$

oui

Mise à jour de la tension d'anode zéro de consigne $CVa0_n = BVa0_n$ — 512

FIG. 5

**EP 4 380 048 B1**

**Documents brevets cités dans la description**

- US 6044001 A

- US 2006234626 A1